# EUROPEAN PATENT APPLICATION

(11) **EP 4 682 549 A1**
(43) Date of publication of application: **21.01.2026**
(21) Application number: 24306199.1
(22) Date of filing: 17.07.2024
(51) Int. Cl.: G01R 19/00, G01R 31/26, H03K 17/00

(54) **A DEVICE FOR ON STATE VOLTAGE MEASUREMENT OF A POWER DEVICE**

(71) Applicant: Mitsubishi Electric R & D Centre Europe B.V., 1119 NS Schiphol Rijk (NL); MITSUBISHI ELECTRIC CORPORATION, Chiyoda-ku Tokyo 100-8310 (JP)
(72) Inventor: LE LESLE, Johan, 35700 RENNES (FR); MORAND, Julien, 35700 RENNES (FR)
(74) Representative: Cabinet Le Guen Maillet

(57) **Abstract**

The present invention concerns a device for on state voltage measurement of a power device, wherein the device for on state voltage measurement of the power device is composed of a first, second and third modules, the first module is a detection module that is connected to the power device and that detects the conduction of the power device, the first module is composed of a diode, a comparison device and an amplifier, the second module is a clamping circuit that is composed of a switch that is controlled by the first module and that is connected to the power device and the third module is the sensing circuit that is connected to the switch and that measures the voltage provided by the switch when the switch is conducting.

## Description

### TECHNICAL FIELD

The present invention relates generally to a device for on state voltage measurement of a power device.

### RELATED ART

The switching frequency of power converter has rapidly increased over the last two decades owing to massive joint improvements in the semiconductor technology and in power packaging. Many markets such as automotive or aircraft, shifting to e-powering, have demanding requirements in terms of power density leading to a high-power throughput of each power device.

As a consequence, the design margin commonly accepted in the past are reduced at each design. In addition, the cost per output power needs to be reduced, especially in the automotive market enabling the mass-production of electric vehicle. In the meantime, wide band gap (WBG) devices are pushing the boundaries of both converter's switching frequency and the maximum allowable junction temperature. In addition, sensing with accuracy the junction temperature of any switching device is a key enabler for a safe power conversion.

Another trend in power conversion is the lifetime prediction of critical device like power switches. The evolution of the junction temperature over time is the principal input parameter for this lifetime estimation since aging is caused by a repetitive thermal stress in the module. In that prospect, high frequency power cycling campaigns, sometimes following an application-specific mission profile, are carried out to validate degradation models or to build a database for constructing a model. Compared to DC power cycling, in high frequency power cycling, the device is tested in conditions close to a real application case but the presence of high-speed switching brings additional constraints for the temperature measurement.

Another possibility for indirect measurement is to use the semiconductor itself as a sensor. Contact-less method such as wavelength analysis of the light emission of the semiconductor dice is often costly and requires having an optical access to the device. Another option is to measure indirectly the junction temperature by electrically sensing temperature-dependent parameters. Among them, some can be conducted online during regular converter operation or must be performed offline.

One widely used Temperature Sensitive Electrical Parameter (TSEP) is the on-state voltage of the device which is compatible with both unipolar and bipolar components.

For unipolar devices like MOSFET, the on-state voltage is only an intermediate variable for estimating the temperature. The actual TSEP is the on-state resistance (RDSON). An accurate measurement of the device current is therefore needed to calculate the junction temperature. Both trends of high-power density converter and lifetime prediction lead to the necessity of an accurate indirect measurement of the junction temperature in both DC and switched operation.

The core idea of junction temperature estimation is to correlate the evolution of a measured parameter with the temperature. In the case at hand, the on-state voltage, named VON, will be the measured parameter. In high switching frequency operation, the device is alternatively turned on and off. Consequently, the availability of the device for measurement is time-limited and dependent on the operation state. As the switching frequency tends to increase with improved devices, the time window for VON acquisition is drastically reduced. For example, a DC-DC power converter operating at a switching frequency of 155 kHz, with a minimum duty ratio of one tenth, the duration of the one-state is only 645 ns. A higher switching frequency will accordingly further reduce the on-state time, so the available time to perform VON measurement.

Another aspect of the high frequency operation is the presence of the bus voltage applied on the device during the off state. This high voltage is also the source of constraints for the temperature sensing unit.

### SUMMARY OF THE INVENTION

The present invention aims to solve several problems stemming from fast switching devices available today and even faster devices in the future. The first problem is the speed limitation of the on-state voltage measurement unveiled by high switching frequency of present and future power converter. The second addressed problem is the fact that existing solutions cannot handle fast transients brought by component with high performance packaging. These transients imply to have either a slow and bulky measurement circuit that also will need high heat dissipation or to reduce the accuracy of the measurement due to spike during the transient on the acquisition circuit.

To that end, the present invention concerns a device for on state voltage measurement of a power device, characterized in that the device for on state voltage measurement of the power device is composed of a first, second and third modules, the first module is a detection module that is connected to the power device and that detects the conduction of the power device, the first module is composed of a diode, a comparison device and an amplifier, the second module is a clamping circuit that is composed of a switch that is controlled by the first module and that is connected to the power device and drives the third module which is the sensing circuit that is connected to the switch and that measures the voltage provided by the switch when the switch is conducting.

Thus, the present invention enables to reach fast response by turning on the switch faster than its self-turn-on mechanism without suffering for the temperature dependent diode's voltage drop during the measurement.

By such configuration, the first and second modules work in parallel. The first module assumes the task of detection separately from the function of the second and third modules are related to measurement function.

According to a particular feature, the comparison device is connected to the diode and comprises a voltage reference and a comparator.

Thus, the reference voltage value is set to a higher value than the on-state voltage. By doing so, the detection can occur ahead of time and the propagation delays of the detection system can be compensated.

According to a particular feature, the comparison device further comprises a voltage source and a resistor connected in series.

Thus, the power device gate driver's isolated supply can simply be used, limiting the number of required components, the constraint here is to guarantee that the voltage source is higher than a voltage reference.

According to a particular feature, the comparison device further comprises a current source and a resistor connected in parallel.

Thus, the diode biasing current is settled by the current source and the resulting voltage from the current source and the resistor during the off-state is guaranteed to be higher than the reference voltage.

According to a particular feature, the first and third modules further comprise protection devices for limiting voltage transients.

According to a particular feature, the third module comprises a resistor the value of which is between 0.1 to 100 ohms.

According to a particular feature, voltage reference value is adjusted according to the technical specifications of the power device.

### BRIEF DESCRIPTION OF THE DRAWINGS

The characteristics of the invention will emerge more clearly from a reading of the following description of example embodiments, the said description being produced with reference to the accompanying drawings, among which:
Fig. 1 represents an example of a converter in which the present invention is implemented;
Fig. 2a represents a first example of a fast voltage clamping circuit for on state voltage measurement according to the present invention;
Fig. 2b represents a second example of a fast voltage clamping circuit for on state voltage measurement according to the present invention;
Figs. 3a to 3d represent signals variations during the turn-ON operation of the first example of a fast voltage clamping circuit for on state voltage measurement according to the present invention;
Figs. 3e to 3h represent signals variations during the turn-OFF operation of the first example of a fast voltage clamping circuit for on state voltage measurement according to the present invention.

### DESCRIPTION

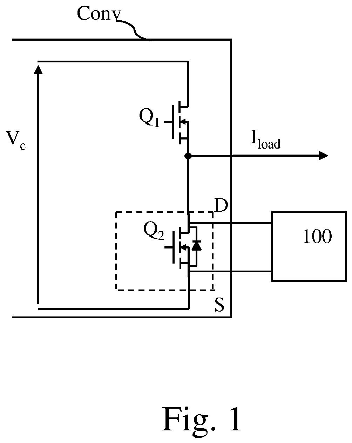

**Fig. 1** represents an example of a converter in which the present invention is implemented.

The convertor Conv comprises at least a voltage source connected V_{c} to two power devices (semiconductors) Q₁ and Q₂ connected in a totem pole configuration and providing a current I_{load} to a load not shown in Fig. 1.

The on-state voltage of at least one power device, the power device Q2 in the example of Fig. 1, is monitored by a fast voltage clamping circuit for on state voltage measurement circuit 100. The value of the on-state voltage provides information about the junction temperature of the power devices.

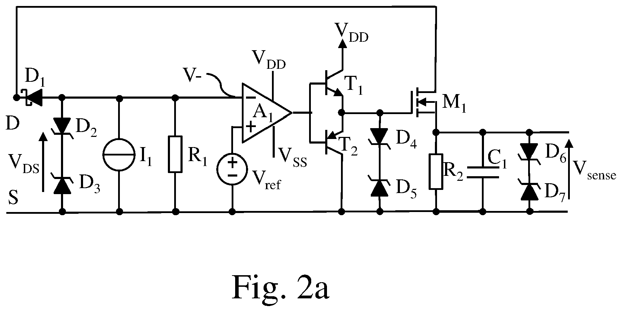

**Fig. 2a** represents a first example of a fast voltage clamping circuit for on state voltage measurement according to the present invention.

The fast voltage clamping circuit for on state voltage measurement of the power device is composed of a first, second and third modules.

The first module is a detection module that is connected to the power device and that detects the change of state of the power device, the first module is composed of a diode, a comparison device and an amplifier.

The second module is a controlled clamping circuit that is composed of a switch that is controlled by the first module and that is connected to the power device.

The third module is the sensing circuit that is connected to the switch and that measures the voltage provided by the switch when the switch is conducting.

The fast voltage clamping circuit for on state voltage measurement module 100 is composed of a diode D₁, six Zener diodes D₂ to D₇, a current source Ii, two resistances R₁ and R₂, a voltage reference V_{ref}, a comparator A₁, three transistors T₁, T₂ and M₁ and a capacitor C₁.

For example, the diode D1 is a Schottky diode. The diode D₁ is low current diode capable of handling the same voltage level as the power device.

The cathode of the diode D₁ is connected to the power device under test Q₂, more precisely to the drain of the power semiconductor Q₂ and to a switch, for example a drain of a MOSFET transistor M₁.

The anode of the Schottky diode D₁ is connected to the anode of the Zener diode D₂, to a positive terminal of the current source Ii, to a first terminal of the resistor R₁ and to a negative input of the comparator A₁.

The cathode of the Zener diode D₂ is connected to the cathode of the Zener diode D₃.

The anode of the Zener diode D₃, a negative terminal of the current source Ii, a second terminal of the resistor R₁ and a negative terminal of the voltage reference V_{ref} are connected to the device under test Q₂, more precisely to the source of the power semiconductor Q₂.

The Zener diodes D₂ and D₃ are protection devices used for limiting voltage transients.

A positive terminal of the voltage reference V_{ref} is connected to a positive input of the comparator A₁.

The output of the comparator A₁ is, if the output power of the comparator A1 is lower than the switch M1 requirements, connected to a pair of switches in a push pull configuration, for example to the base of a NPN transistor T₁ and to the base of the PNP transistor T₂.

The collector of the transistor T₁ is connected to a positive voltage source V_{DD}.

The emitter of the transistor T₁ is connected to the emitter of the transistor T₂, to the gate of the MOSFET transistor M₁ and to the anode of the Schottky diode D₄.

The cathode of the Zener diode D₄ is connected to the cathode of the Zener diode D₅.

The Zener diodes D₄ and D₅ are protection devices used for limiting voltage transients.

The source of the MOSFET transistor M₁ is connected to a first terminal of the resistor R₂, to a first terminal of the capacitor C₁ and to the anode of the Zener diode D₆.

The resistor R₂ value is between 0.1 to 100 Ohms, for example equals to 10 Ohms.

The resistor R2 value is defined in order to provide high speed transitions and is defined according to the parasitic capacitances at the "V_{Sense}" connections.

The cathode of the Zener diode D₆ is connected to the cathode of the Zener diode D₇.

The Zener diodes D₆ and D₇ are protection devices used for limiting voltage transients.

The collector of the transistor T₂, the second terminal of the capacitor C₁, the second terminal of the resistor R₂ and the anode of the Zener diode D₇ are connected to the device under test Q₂, more precisely to the source of the power device Q₂.

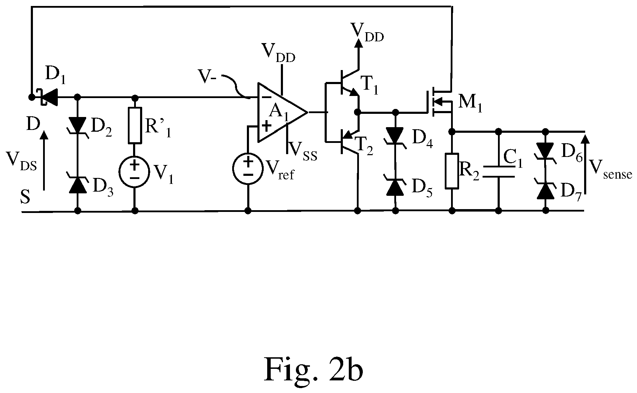

**Fig. 2b** represents a second example of a fast voltage clamping circuit for on state voltage measurement according to the present invention.

The fast voltage clamping circuit for on state voltage measurement of the power device is composed of a first, second and third modules.

The first module is a detection module that is connected to the power device and that detects the conduction of the power device, the first module is composed of a diode, a comparison device and a comparator.

The second module is a clamping circuit that is composed of a switch that is controlled by the first module and that is connected to the power device.

The third module is the sensing circuit that is connected to the switch and that measures the voltage provided by the switch when the switch is conducting.

The fast voltage clamping circuit for on state voltage measurement module 100 is composed of a diode D₁, six Zener diodes D₂ to D₇, a voltage source Vi, two resistances R'₁ and R₂, a voltage reference V_{ref}, a comparator A₁, three transistors T₁, T₂ and M₁ and a capacitor C₁.

For example, the diode D1 is a Schottky diode. The diode D1 is low current diode capable of handling the same voltage level as the power device.

The cathode of the diode D₁ is connected to the device under test Q₂, more precisely to the drain of the power semiconductor Q₂ and to the drain of the transistor MOSFET M₁.

The anode of the diode D₁ is connected to the anode of the Zener diode D₂, to a first terminal of the resistor R'₁ and to a negative input of the comparator A₁.

The cathode of the Zener diode D₂ is connected to the cathode of the Zener diode D₃.

The Zener diodes D₂ and D₃ are protection devices used for limiting voltage transients.

The anode of the Zener diode D₃, a negative terminal of the voltage source Vi, and a negative terminal of the voltage reference V_{ref} are connected to the device under test Q₂, more precisely to the source of the power semiconductor Q₂.

A second terminal of the resistor R'₁ is connected to a positive terminal of the voltage source V₁.

A positive terminal of the voltage reference V_{ref} is connected to a positive input of the comparator A₁.

The resistor R'₁ and the voltage source V₁ form a biasing circuit for diode D1 allowing to follow the conduction state of the power device.

The output of the comparator A₁ is connected to the base of the NPN transistor T₁ and to the base of the PNP transistor T₂.

The collector of the transistor T₁ is connected to a positive voltage source V_{DD}.

The emitter of the transistor T₁ is connected to the emitter of the transistor T₂, to the grid of the MOSFET transistor M₁ and to the anode of the Zener diode D₄.

The cathode of the Zener diode D₄ is connected to the cathode of the Zener diode D₅.

The Zener diodes D₄ and D₅ are protection devices used for limiting voltage transients.

The drain of the MOSFET transistor M₁ is connected to a first terminal of the resistor R₂, to a first terminal of the capacitor C₁ and to the anode of the Zener diode D₆.

The resistor R₂ value is lower than 50 Ohms, for example equals to 10 Ohms.

The cathode of the Zener diode D₆ is connected to the cathode of the Zener diode D₇.

The Zener diodes D₆ and D₇ are protection devices used for limiting voltage transients.

The collector of the transistor T₂, the second terminal of the capacitor C₁, the second terminal of the resistor R₂ and the anode of the Zener diode D₇ are connected to the device under test Q₂, more precisely to the source of the power semiconductor Q₂.

It has to be noted here that the examples of the fast voltage clamping circuit for on state voltage measurement module 100 given in Figs. 2a and 2b are equivalent according to the Norton's theorem.

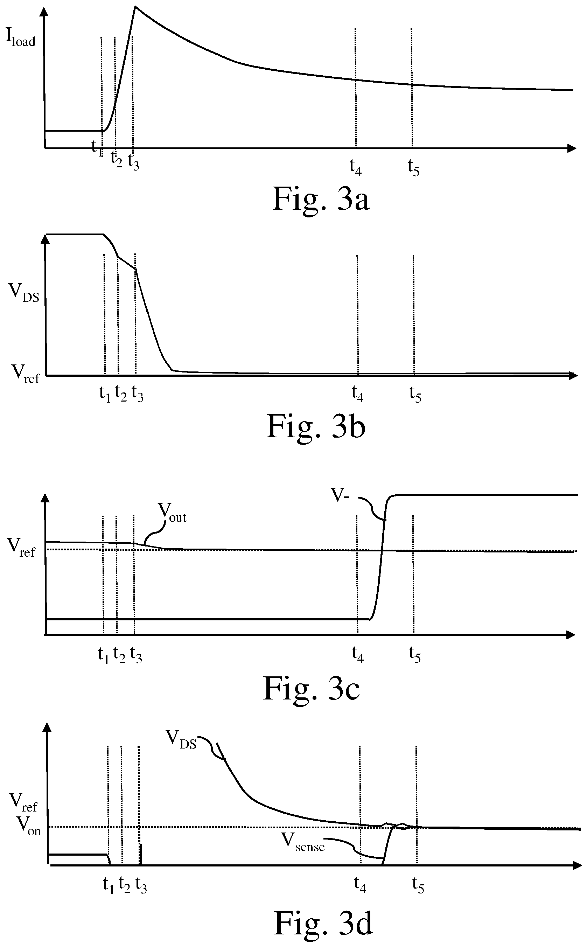

Figs. 3a to 3h represent signals variations during the operation of the first example of a fast voltage clamping circuit for on state voltage measurement according to the present invention.

For Figs.3a to 3h, the horizontal axis represents the time.

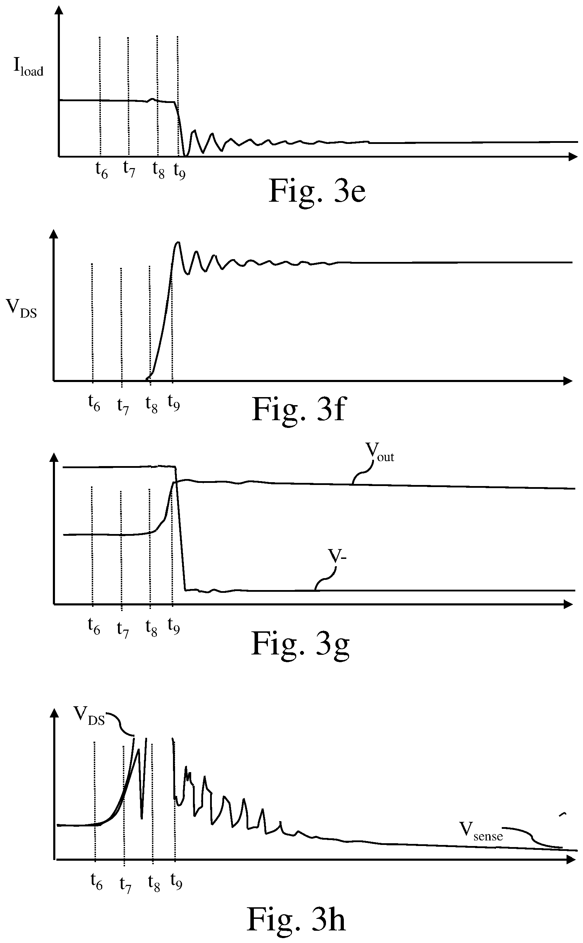

The vertical axis of Figs. 3a and 3e represents the load current I_{load} variations.

The vertical axis of Figs. 3b and 3f represents the voltage V_{DS} of the power device Q₂.

The vertical axis of Figs. 3c and 3g represents variations of the voltage V- at the negative input of the comparator A₁ and the voltage Vₒᵤₜ at the output of the comparator A₁.

The vertical axis of Figs. 3d and 3h represents variations of the voltage Vₛₑₙₛₑ of the capacitor C₁ and the voltage V_{DS} at the negative input of the comparator A₁ and the voltage Vout at the output of the comparator A₁.

Prior the time t1 the power device Q₂ is OFF (not conducting), the diode D1 and the transistor Q₂ are withstanding the DC bus voltage VDC.

At time t=t1, the power device Q₂ starts to conduct, the drain current starts rising. During the t1-t2 period, the current transient induces a steep decrease (notch) in the drain-source voltage due to the positive di/dt through parasitic inductance not shown in Fig. 1. However, the voltage is still too high to trigger the fast voltage clamping circuit for on state voltage measurement.

At time t=t2, the current value in the power device Q₂ reaches the load current level. The opposite power device Q₁ does not carry any current and starts to block voltage. Consequently, the power device Q₂ experiences a decreasing voltage. Simultaneously, the fast dv/dt induces a displacement current in the parasitic capacitance not shown in Fig. 1 in the form of a current overshoot. During a first phase of the overshoot (t2<t<t3), the current continues to rise participating to the voltage decrease. The state of the voltage is still too high to trigger the fast voltage clamping circuit for an on state voltage measurement.

At time t=t3, the peak current is reached, and the current slowly decreases until meeting the load current value. The drain to source voltage of the power device Q₂ is now decreasing at a different rate.

At time t=t4, the drain to source voltage of the power device Q₂ matches the set threshold voltage of the fast voltage clamping circuit for on state voltage measurement circuit. The state of the power device Q₂, here the on state, is propagated through all the stages of the fast voltage clamping circuit for on state voltage measurement circuit. Meanwhile the drain to source voltage of the power device Q₂ is still decreasing towards the on-state voltage.

At time t=t5, once the state information has been fully propagated, the transistor M1 is turn-on by the comparator A₁. The current overshoot phase, described earlier, could possibly still be ongoing. If so, the on-state voltage is modulated by the current swing around the load current. At this time, the on-state voltage Vₛₑₙₛₑ value can be measured by the fast voltage clamping circuit for on state voltage measurement circuit.

At time t=t6, the power device Q₂ is turn-off and the drain to source voltage start to rise. Since the gate of the transistor M₁ is kept at a positive voltage (V_{DD} in Figs. 2), the gate to source voltage start to drop due to the increase in the source voltage.

At time t=t7, the gate to source voltage reaches the threshold voltage of the transistor M₁ switch. The transistor M₁ is progressively turned off by the increase in the source voltage. The equivalent impedance of the transistor M₁ starts to rise, changing the voltage divider ratio and therefore modifying the voltage and maintaining the gate to source voltage of the transistor M₁ around the threshold voltage. With this local feedback, an equilibrium is reached where the transistor M₁ is not fully turned off. It handles most of the applied high voltage and carries a leakage current corresponding to its threshold voltage divided by the source resistor.

At time t=t8, the drain to source voltage matches the threshold voltage of the fast voltage clamping circuit for on state voltage measurement circuit. The new state of the power device Q₂, here the off state, is propagated through all the stages of the fast voltage clamping circuit for on state voltage measurement circuit. It should be noted that instants t6 and t7 can be swapped and one can occurs before the other. The controlled clamping circuit and the state detection circuit are two parallel tasks and are not linked by any common timing.

At time t=t9, once the state information has been fully propagated, the transistor M1 is fully turn-off by the comparator A1. The equivalent impedance of the transistor M1 is in the Giga ohms range and the leakage current is at its minimum. Therefore, the off-state losses are drastically reduced.

## Claims

1. A device for on state voltage measurement of a power device, **characterized in that** the device for on state voltage measurement of the power device is composed of a first, second and third modules, the first module is a detection module that is connected to the power device and that detects the conduction of the power device, the first module is composed of a diode, a comparison device and an amplifier, the second module is a clamping circuit that is composed of a switch that is controlled by the first module and that is connected to the power device and the third module is the sensing circuit that is connected to the switch and that measures the voltage provided by the switch when the switch is conducting.

2. The device according to claim 1, **characterized in that** the comparison device is connected to the diode and comprises a voltage reference and a comparator.

3. The device according to claim 2, **characterized in that** the comparison device further comprises a voltage source and a resistor connected in series.

4. The device according to claim 2, **characterized in that** the comparison device further comprises a current source and a resistor connected in parallel.

5. The device according to any of the claims 1 to 4, **characterized in that** the first and third modules further comprise protection devices for limiting voltage transients.

6. The device according to any of the claims 1 to 5, **characterized in that** the third module comprises a resistor the value of which is between 0.1 to 100 ohms.

7. The device according to any of the claims 1 to 6, **characterized in that** the voltage reference value is adjusted according to the technical specifications of the power device.
